# EUROPÄISCHE PATENTANMELDUNG

(11) **EP 1 059 730 A2**
(43) Veröffentlichungstag der Anmeldung: **13.12.2000**
(21) Anmeldenummer: 00201922.2
(22) Anmeldetag: 29.05.2000
(51) Int. Cl.: H03L 7/113

(54) **Anordnung zur Offsetstromkompensation eines Phasendetektors.**

(30) Priorität: 11.06.1999 DE 19926666
(71) Anmelder: Philips Corporate Intellectual Property GmbH, 52064 Aachen (DE); Koninklijke Philips Electronics N.V., 5621 BA Eindhoven (NL)
(72) Erfinder: Kuehn, Hans-Jürgen, 52064 Aachen (DE)
(74) Vertreter: Volmer, Georg, Dipl.-Ing.

(57) **Zusammenfassung**

Bei einer Anordnung zur Offsetstromkompensation eines Phasendetektors (4), welcher in einem Phasenregelkreis (2) vorgesehen ist, dem ein Akqusitionsschaltkreis (7) zugeordnet ist, welcher in einer Einschaltphase des Phasenregelkreises (2) vor Anlegung eines Eingangssignals an den Phasenregelkreis (2) Akquisitionsimpulse in ein in dem Phasenregelkreis (2) vorgesehenes Schleifenfilter (5) einspeist, um die Arbeitsfrequenz eines in dem Phasenregelkreis vorgesehenen steuerbaren Oszillators (6) in ein vorgegebenes Frequenzfensters zu bringen, ist vorgesehen, daß die Anordnung (1) während wenigstens eines Zeitabschnitts der Einschaltphase bei einem Auftreten von Akquisitionsimpulsen einen Offsetkorrekturstrom ermittelt, welcher der Kompensation des Offsetstroms des Phasendetektors (4) dient, wobei die Größe und das Vorzeichen des Offsetkorrekturstroms abhängig von der Häufigkeit und dem Vorzeichen der Akquisitionsimpulse so gewählt wird, daß am Ende der Einschaltphase keine Akquisitionsimpulse mehr auftreten,
und daß die Anordnung (1) den so ermittelten Offsetkorrekturstrom dem Ausgangssignal des Phasenkomparators (4) auch während des Betriebs des Phasenregelkreises außerhalb der Einschaltphase überlagert.

## Beschreibung

Die Erfindung betrifft eine Anordnung zur Offsetstromkompensation eines Phasendetektors, welcher in einem Phasenregelkreis vorgesehen ist, dem ein Akquisitionsschaltkreis zugeordnet ist, welcher in einer Einschaltphase des Phasenregelkreises vor Anlegung eines Eingangssignals an den Phasenregelkreis Akquisitionsimpulse in ein in dem Phasenregelkreis vorgesehenes Schleifenfilter einspeist, um die Arbeitsfrequenz eines in dem Phasenregelkreis vorgesehenen steuerbaren Oszillators in ein vorgegebenes Frequenzfensters zu bringen

Aus der PCT Anmeldung 98-5355482 (PHN 16.366) ist ein Phasenregelkreis bekannt, dem ein Akquisitionsschaltkreis zugeordnet ist. Der Akquisitionsschaltkreis dient dazu, nach dem Anschalten der Stromversorgung und/oder nach einem Reset des Phasenregelkreises die Arbeitsfrequenz des steuerbaren Oszillators dieses Phasenregelkreises in ein Frequenzfenster zu bringen, wodurch ermöglicht wird, daß der Phasenregelkreis beim Anlegen eines Eingangssignals an den Phasenregelkreis auf dessen Frequenz einrasten kann. Insbesondere bei schmalbandiger Auslegung des Phasenregelkreises ist dieses erforderlich, da der Phasenregelkreis anderenfalls nicht auf die Frequenz des Eingangssignals einrasten kann. Dieser Akquisitionsschaltkreis liefert also eine Art Fanghilfe. Realisiert wird dies durch Akquisitionsimpulse, die in das Schleifenfilter eingespeist werden und die die Frequenz des steuerbaren Oszillators so lange nachsteuern, bis dessen Frequenz in dem Frequenzfenster liegt.

Diese Anordnung ist zwar als Fanghilfe in dem Sinne geeignet, das sie ein Einrasten des Phasenregelkreises auf ein Eingangssignal erleichtert, sie ist jedoch nicht in der Lage, Offsetströme des Phasendetektors zu kompensieren. Weist der Phasendetektor des Phasenregelkreises Offsetströme auf, so kann zwar durch den Akquisitionsschaltkreis dennoch ein Einrasten des Phasenregelkreises auf die Frequenz des Eingangssignals sichergestellt werden, der Phasenregelkreis arbeitet jedoch in Schieflage, da er ständig den Offsetstrom seines Phasendetektors kompensieren muß. Dies wiederum bedeutet, daß sich die beiden Eingangssignale des Phasendetektors nicht in der gewünschten Phasenlage zueinander befinden, sondern in einer davon abweichenden Phasenlage, die dadurch daß der Offsetstrom des Phasendetektors durch diesen quasi ausgeglichen werden muß.

Es ist Aufgabe der Erfindung, eine Anordnung zur Kompensation des Offsetstroms des Phasendetektors in einem derartigen Phasenregelkreis anzugeben, dem ein Aquisitionsschaltkreis zugeordnet ist.

Diese Aufgabe ist erfindungsgemäß dadurch gelöst, daß die Anordnung während wenigstens eines Zeitabschnitts der Einschaltphase bei einem Auftreten von Akquisitionsimpulsen einen Offsetkorrekturstrom ermittelt, welcher der Kompensation des Offsetstroms des Phasendetektors dient, wobei die Größe und das Vorzeichen des Offsetkorrekturstroms abhängig von der Häufigkeit und dem Vorzeichen der Akquisitionsimpulse so gewählt wird, daß am Ende der Einschaltphase keine oder sehr selten Akquisitionsimpulse mehr auftreten,
und daß die Anordnung den so ermittelten Offsetkorrekturstrom dem Ausgangssignal des Phasenkomparators auch während des Betriebs des Phasenregelkreises außerhalb der Einschaltphase überlagert.

Die erfindungsgemäße Anordnung zur Offsetstromkompensation macht sich den Aquisitionsschaltkreis bzw. die von diesem gelieferten Akquisitionsimpulse zunutze, um eine Kompensation des Offsetstroms des Phasenkomparators zu erzielen. Treten nämlich auch dann noch Aquisitionsimpulse auf, wenn die Arbeitsfrequenz des steuerbaren Oszillators wenigstens vorübergehend in dem vorgegebenen Frequenzfenster lag, so deutet dies darauf hin, daß die Arbeitsfrequenz des steuerbaren Oszillators durch einen Offsetstrom beeinflußt wird. Daher schaltet die Anordnung während wenigstes eines Zeitabschnitts der Einschaltphase, insbesondere eines Abschnittes gegen Ende der Einschaltphase, bei einem Auftreten von Aquisitionsimpulsen einen Offsetkorrekturstrom. Dieser Offsetkorrekturstrom dient der Kompensation des Offsetstroms des Phasendetektors des Phasenregelkreises und kann entweder unmittelbar in den Phasenregelkreis oder in den Phasendetektor selber eingespeist werden. Abhängig davon, wie viele Aquisitionsimpulse auftreten und welche Vorzeichen diese aufweisen, wird der Offsetkorrekturstrom so ermittelt, daß am Ende der Einschaltphase möglichst keine Aquisitionsimpulse mehr auftreten. Dies bedeutet, daß die Arbeitsfrequenz des steuerbaren Oszillators stabil ist, was eine Folge der Offsetstromkompensation darstellt, da dann der Phasendetektor keinen Offsetstrom mehr liefert, der ein Wegdriften der Arbeitsfrequenz des steuerbaren Oszillators zur Folge hätte.

Diese Emittlung des Offsetkorrekturstroms wird wenigstens während eines Zeitabschnitts der Einschaltphase vorgenommen. Im einfachsten Falle kann die Ermittlung der Größe des Offsetkorrekturstroms und von dessen Vorzeichen während der gesamten Einschaltphase vorgenommen werden. Es wird zwar dann zu Beginn der Einschaltphase ein falscher Offsetkorrekturstrom ermittelt, da in dieser Phase die Frequenz des steuerbaren Oszillators ohnehin noch nicht durch den Aquisitionsschaltkreis in das Frequenzfenster gekracht wurde. Gegen Ende der Einschaltphase, deren Länge so gewählt ist, daß der Aquisitionsschaltkreis in jedem Falle in der Lage die Frequenz des steuerbaren Oszillators in das Frequenzfenster zu bringen, sollte jedoch das Frequenzfenster erreicht sein und die Ermittlung des Offsetkorrekturstroms wird in dieser Endphase der Einschaltphase zur korrekten Bestimmung des Offsetkorrekturstroms führen. Es ist auch möglich und sogar vorteilhaft, die Ermittlung des Offsetkorrekturstromes während eines Zeitabschnitts der Einschaltphase vorzunehmen, die am Ende der Einschaltphase liegt, da dort die Wahrscheinlichkeit groß ist, das Auftreten der Aquisitionsimpulse ausschließlich durch Offsetkorrekturströme verursacht werden.

Die oben beschriebene Arbeitsweise der Anordnung und die Ermittlung der Offsetkorrekturströme findet während der Einschaltphase statt, in der an den Phasenregelkreis kein Eingangssignal angelegt wird. Ist der Offsetkorrekturstrom durch die erfindungsgemäße Anordnung ermittelt worden und ist die Einschaltphase abgeschlossen, so wird an den Phasenregelkreis das Eingangssignal angelegt, auf das der Phasenregelkreis rasten soll. Wesentlich ist, daß der ermittelte Offsetkorrekturstrom auch nach dem Ende der Einschaltphase eingeschaltet bleibt, da er nun der Korrektur des Offsetstroms des Phasendetektors des Phasenregelkreises in dessen normalen Betrieb dienen soll und hier seine eigentliche Wirkung entfaltet. Im Gegensatz zu den Aquisitionsimpulsen, die im normalen Betrieb des Phasenregelkreises nicht mehr geschaltet werden, bleibt also der Offsetkorrekturstrom eingeschaltet.

Es wird hierdurch eine optimale Arbeitsweise des Phasenregelkreises erzielt, da dieser auch dann, wenn der Phasendetektor einen Offsetstrom liefert, nicht mehr in Schieflage arbeitet, da der Offsetstrom durch den Offsetkorrekturstrom der erfindungsgemäßen Anordnung kompensiert wird. Es ist somit unabhängig von der Existenz und der Größe eines Offsetstroms immer eine optimale Arbeitsweise des Phasenregelkreises gewährleistet. Dies ist insbesondere deshalb von Bedeutung, weil derartige Phasenregelkreise in der Regel integriert werden und die Toleranzen der Schaltungselemente in einem derartigen integrierten Schaltkreis relativ groß sind, so daß durch Unsymmetrien und andere Effekte ein integrierter Phasendetektor häufig Offsetströme liefert, die nicht selten auch so groß sind, daß die gesamte Schaltung unbrauchbar wird. Durch die erfindungsgemäße Anordnung können auch derartige, an sich unbrauchbare Exemplare wegen der Offsetstromkompensation optimal arbeiten und müssen nicht als Ausschuß angesehen werden.

Bei einer gemäß Anspruch 2 vorgesehenen Ausgestaltung der Erfindung wird die Ermittlung der Größe und des Vorzeichens des Offsetkorrekturstromes schrittweise vorgenommen. Die Anordnung arbeitet in sogenannten Korrekturzyklen, wobei in jedem Zyklus ein Auftreten eines Akquisitionsimpulses und gegebenenfalls dessen Vorzeichen beobachtet wird. Tritt in einem Zyklus ein solcher Akquisitionsimpuls auf, so wird abhängig von dessen Vorzeichen dem Offsetkorrekturstrom ein Korrekturteilstrom zugeschaltet, dessen Vorzeichen so gewählt ist, daß er geeignet ist, den Drift der Frequenz des steuerbaren Oszillators zu verringern, also den Offsetstrom des Phasendetektors zu verringern.

Dieser Vorgang wiederholt sich in jedem Korrekturzyklus, so daß in jedem Korrekturzyklus die Größe des Offsetkorrekturstroms durch hinzugeschaltete Korrekturteilströme immer besser dem Idealwert angenähert wird. Diese in Korrekturzyklen vorgenommene schrittweise Anpassung des Offsetkorrekturstoms an den tatsächlich vorhandenen Offsetstrom kann vorteilhaft mittels der in Anspruch 3 angegebenen weiteren Ausgestaltung der Erfindung vorgenommen werden. Das hierbei vorgesehene Register schaltet die Korrekturteilströme und dient gleichzeitig dazu, zu speichern, welche Korrekturteilströme ermittelt wurden. Dies ist wesentlich, da die Korrekturteilströme und somit der Offsetstrom im normalen Betrieb ständig eingeschaltet bleiben.

Dabei können vorteilhaft, wie gemäß einer weiteren Ausgestaltung der Erfindung nach Anspruch 4 vorgesehen ist, Stromquellen jeweils gleicher Größe vorgesehen sein. Diese Stromquellen haben zur Hälfte positives und zur Hälfte negatives Vorzeichen, weisen aber jeweils gleichen Betrag auf. Diese n Korrekturteilströme sind mittels des Registers schaltbar. Diese Ausgestaltung gestattet beispielsweise die Realisierung der Stromquellen mittels eines einzigen Stromspiegels mit mehreren Ausgangstransistoren.

Bei der Arbeitsweise der erfindungsgemäßen Anordnung in Korrekturzyklen, in denen die optimale Größe des Offsetkorrekturstroms ermittelt wird, ist es vorteilhaft, wie gemäß einer weiteren Ausgestaltung der Erfindung nach Anspruch 5 vorgesehen ist, diese an die Arbeitszyklen des Akquisitionsschaltkrieses anzupassen, da dann in jedem Korrekturzyklus gegebenenfalls nur ein Akquisitionsimpuls auftritt, der auszuwerten ist.

Eine weitere Ausgestaltung der Erfindung nach Anspruch 8 bietet den Vorteil, daß die Größe des Offsetkorrekturstroms erst dann ermittelt wird, wenn die Arbeitsfrequenz des steuerbaren Oszillators in dem Frequenzfenster liegt oder wenigstens in dessen Nähe liegt. Es kann dann davon ausgegangen werden, daß ein weiteres Abdriften der Frequenz des steuerbaren Oszillators durch einen Offsetstrom verursacht ist.

Der Offsetkorrekturstrom kann, wie gemäß weiteren Ausgestaltungen der Erfindung nach den Ansprüchen 9 und 10 vorgesehen ist, entweder in das Ausgangssignal des Phasenkomparators und damit in das Eingangssignal des Schleifenfilters eingespeist werden oder kann innerhalb des Phasendetektors dazu herangezogen werden, den Offsetstrom zu verringern. Dies kann beispielsweise dadurch geschehen, daß der Offsetkorrekturstrom Strömen überlagert wird, die Stromquellen für einen Differenzverstärker in dem Phasendetektor liefern. In diesem Falle wird unmittelbar an der Ursache des Offsetstroms eine Korrektur vorgenommen.

Nachfolgend wird ein Ausführungsbeispiel der Erfindung anhand der Zeichnung näher erläutert. Es zeigen:
Fig. 1 ein Blockschaltbild eines Phasenregelkreises mit einem zugeordneten Aquisitionsschaltkreis und mit einer erfindungsgemäßen Anordnung zur Offsetstromkompensation,
Fig. 2 ein Blockschaltbild der Anordnung zur Offsetstromkompensation gemäß Fig. 1 und
Fig. 3 einige über der Zeit aufgetragene Signale der Anordnung gemäß Fig. 1 während der Endphase einer Einschaltphase.

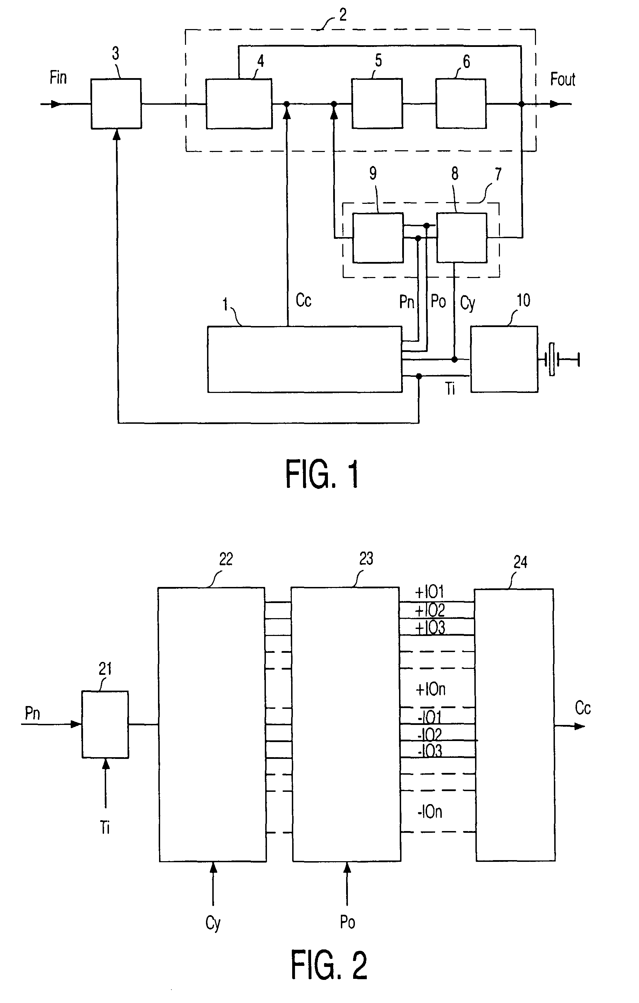

Das Blockschaltbild gemäß Fig. 1 zeigt eine erfindungsgemäße Anordnung 1 zur Offsetstromkompensation, die einem Phasenregelkreis 2 zugeordnet ist.

Dem Phasenregelkreis 2 ist ein Schalter 3 vorgeschaltet, dem eingangsseitig ein Eingangssignal Fin zuführbar ist. Mittels des Schalters 3 kann dieses auf einem in dem Phasenregelkreis 2 vorgesehenen Phasendetektor 4 geschaltet werden. Dem Phasendetektor 4 sind ein Schleifenfilter 5 und ein steuerbarer Oszillator 6 nachgeschaltet, dessen Ausgangssignal das Ausgangssignal des Phasenregelkreises darstellt, das in der Figur mit Fout gekennzeichnet ist. Dieses Ausgangssignal des steuerbaren Oszillators 6 wird einem zweiten Eingang des Phasendetektors 4 zugeführt.

Zur Vermeidung von gesonderten, dem Phasenregelkreis 2 vorgeschalteten Filtern werden derartige Phasenregelkreise meist sehr schmalbandig ausgelegt, so daß sie eine eigene Selektivität haben. Dabei tritt jedoch das Problem auf, daß ein derartiger Phasenregelkreis nur in einem sehr engen Frequenzbereich fängt, d.h. die Frequenz des Eingangssignals Fin nur in einem sehr engen Frequenzbereich zum Einrasten des Phasenregelkreises auf diese Frequenz führt.

Daher ist es vorteilhaft, dem Phasenregelkreis 2 einen Aquisitionsschaltkreis 7 zuzuordnen, welcher nach dem Stande der Technik bekannt ist und welcher dazu dient, die Arbeitsfrequenz des steuerbaren Oszillators 6 des Phasenregelkreises 2 bei nicht angelegtem Eingangssignal Fin in ein Frequenzfenster zu bringen. Liegt nämlich die Arbeitsfrequenz des steuerbaren Oszillators 6 in diesem Frequenzfenster und wird dann das Eingangssignal zugeschaltet, kann der Phasenregelkreis einwandfrei auf die Frequenz des Eingangssignals Fin rasten.

Um dies zu erreichen, ist innerhalb des Akquisitionsschaltkreises 7 eine Steuerung 8 vorgesehen, welche die Arbeitsfrequenz des steuerbaren Oszillators 6 des Phasenregelkreises 2 feststellt und abhängig von dessen momentaner Arbeitsfrequenz Steuersignale an eine Ausgangsstufe 9 des Akquisitionsschaltkreises 7 gibt, welche ihrerseits Akquisitionsimpulse in das in das Schleifenfilter 5 eingespeiste Signal liefert. Dabei ist die Häufigkeit und die Vorzeichen der Akquisitionsimpulse so gewählt, daß durch die Akquisitionsimpulse die Arbeitsfrequenz des steuerbaren Oszillators 6 in Richtung auf das vorgegebene Frequenzfenster verändert wird. Liegt beispielsweise nach dem Einschalten in der Einschaltphase, in der das Eingangssignal Fin noch nicht auf den Phasenregelkreis 2 geschaltet ist, die Arbeitsfrequenz des steuerbaren Oszillators deutlich unterhalb des vorgegebenen Frequenzfenster, so wird der Akquisitionsschaltkreis 7 solche Akquisitionsimpulse in das Schleifenfilter 5 einspeisen, daß diese zu einer Erhöhung der Arbeitsfrequenz des steuerbaren Oszillators 6 führen. Vorteilhaft arbeitet dabei der Akquisitionsschaltkreis 7 in Arbeitszyklen, wobei je Arbeitszyklus die Frequenz des steuerbaren Oszillators neu gemessen und gegebenenfalls ein neuer Akquisitionsimpuls erzeugt und eingespeist wird. Dieser Vorgang wiederholt sich so lange, bis die Arbeitsfrequenz des steuerbaren Oszillators 6 in dem vorgegebenen Frequenzfenster zu liegen kommt.

Bei einer optimalen Arbeitsweise des Phasenregelkreises und insbeondere von dessen Phasendetektor 4 müßte dann die Arbeitsfrequenz des steuerbaren Oszillators 6 konstant in dem vorgegebenen Fenster liegen, so daß auch die Einspeisung weiterer Akquisitionsimpulse nicht mehr erforderlich wäre. Tatsächlich liefern jedoch viele Phasendetektoren Offsetströme, die dazu führen, daß auch dann, wenn die Arbeitsfrequenz des steuerbaren Oszillators mittels der Akquisitionsimpulse in das Frequenzfenster gebracht wurde, dennoch ein weiteres Abdriften der Arbeitsfrequenz des steuerbaren Oszillators 6 eintrifft, wobei das Vorzeichen des Abdriftens abhängig ist von dem Vorzeichen des Offsetstroms. Mit anderen Worten ist die Arbeitsfrequenz des steuerbaren Oszillators 6 bei Auftreten von Offsetströmen nicht konstant und muß immer wieder mittels der Akquisitionsimpulse in das Frequenzfenster zurückgebracht werden.

Es kann zwar auf diese Weise durch immer wieder vorgenommene Korrektur der Frequenz des steuerbaren Oszillators 6 mittels der Akquisitionsimpulse ein Einrasten des Phasenregelkreises 2 auf die Frequenz des Eingangssignals Fin nach dessen Anschalten an den Phasenregelkreis erzielt werden. Liefert jedoch der Phasendetektor 4 einen Offsetstrom, so arbeitet der Phasenregelkreis dann in einer sogenannten Schieflage. Die Schieflage besteht darin, daß die Phasenbeziehungen der beiden Eingangssignale des Phasendetektors 4 nicht wie gewünscht sind, also beispielsweise nicht exakt 90° betragen. Durch den Offsetstrom, den der Phasendetektor 4 liefert, weisen die Eingangssignale eine davon abweichende Phasenlage zueinander auf, die erforderlich ist, um den Offsetstrom des Phasendetektors zu kompensieren. Da für viele Anwendungen die Phasenlage der beiden Signale wesentlich ist, ist dieser Effekt zu vermeiden.

Hierzu ist die erfindungsgemäße Anordnung 1 zur Offsetstromkompensation vorgesehen. Diese liefen einen Offsetkorrekturstrom Cc, der entweder in den Signalweg zwischen Ausgang des Phasendetektors und Eingang des Schleifenfilters 5 eingespeist wird oder der direkt in den Phasendetektor 4 eingespeist wird und dort beispielsweise Strömen überlagert wird, die von Stromquellen geliefert werden, die den Differenzverstärker des Phasendetektors speisen.

Die Ermittlung der Größe dieses Offsetkorrekturstroms Cc muß in jedem Falle in der Einschaltphase vorgenommen werden, da in dieser Einschaltphase das Eingangssignal Fin noch nicht auf den Phasenregelkreis 2 geschaltet ist und dieser noch frei arbeitet.

Wie oben beschrieben, wird in der Einschaltphase mittels des Akquisitionsschaltkreises 7 eine Korrektur der Arbeitsfrequenz des steuerbaren Oszillators 6 mittels Akquisitionsimpulsen vorgenommen. Die erfindungsgemäße Anordnung 1 macht sich diese Akquisitionsimpulse oder Steuersignale, die die Akquisitionsimpulse auslösen, zunutze, indem sie diese nach ihrem Auftreten und nach ihrem Vorzeichen auswertet und daraus die optimale Größe des Offsetkorrekturstroms Cc ermittelt.

Derjenige Zeitabschnitt, in dem die erfindungsgemäße Anordnung arbeitet, muß in jedem Falle innerhalb der Einschaltphase liegen. Sie kann im Extremfall die gesamte Einschaltphase betragen, vorteilhaft wird jedoch ein Zeitabschnitt am Ende der Einschaltphase gewählt.

Derjenige Zeitabschnitt, in dem die erfindungsgemäße Anordnung 1 zur Offsetstromkompensation arbeitet, wird mittels einer Ablaufsteuerung 10 vorgegeben, welche ein Signal Ti liefert, das diese Zeitspanne angibt. Dieses Signal wird der Anordnung 1 zugeführt.

Die Ablaufsteuerung 10 liefert ferner ein Zyklussignal Cy, welches sowohl in dem Akquisitionsschaltkreis 7 wie auch in der erfindungsgemäßen Anordnung 1 zur Bestimmung der Arbeitszyklen eingesetzt wird. Dies ist vorteilhaft, da auf diese Weise die Arbeitszyklen der erfindungsgemäßen Anordnung 1 an die Arbeitszyklen des Akquisitionsschaltkreises 7 angepaßt sind und somit pro Arbeitszyklus der erfindungsgemäßen Anordnung 1 maximal ein Akquisitionsimpuls auftreten kann.

In dem in der Fig. 1 dargestellten Ausführungsbeispiel wertet die erfindungsgemäße Anordnung 1 die Akquisitionsimpulse des Akquisitionsschaltkreises 7 nicht unmittelbar aus, sondern wertet Steuersignale Pn und Po aus, die von der Steuerung 8 des Akquisitionsschaltkreises 7 geliefert werden. Die Auswertung der Steuersignale ist einfacher als die unmittelbare Auswertung der Akquisitionsimpulse, letzteres ist jedoch auch möglich.

In dem Steuersignal Pn tritt dann ein Impuls auf, wenn die Ausgangsstufe 9 des Akquisitionsschaltkreise 7 einen Akquisitionsimpuls liefert. Das Steuersignal Po liefert hingegen eine Information über das Vorzeichen des Akquisitionsimpulses.

Die erfindungsgemäße Anordnung 1 zur Offsetstromkompensation wertet diese Signale aus. Dabei kann vorteilhaft in jedem Arbeitszyklus festgestellt werden, ob der Akquisitionsschaltkreis 7 einen Akquisitionsimpuls erzeugt und wenn ja welches Vorzeichen dieser hat. Aus dieser Information kann die Anordnung 1 darauf schließen, in welcher Richtung eine Korrektur der Arbeitsfrequenz des steuerbaren Oszillators 6 vorgenommen wird.

Insbesondere gegen Ende der Einschaltphase sollte die Arbeitsfrequenz des steuerbaren Oszillators 6, wie oben erläutert, konstant in dem Frequenzfenster liegen. Treten dennoch Akquisitionsimpulse auf, so ist dies ein Zeichen dafür, daß der Phasenkomparator 4 des Phasenregelkreises 2 einen Offsetstrom liefert, der ein Wegdriften der Arbeitsfrequenz des steuerbaren Oszillators 6 verursacht.

Genau dieser Offsetstrom ist durch die erfindungsgemäße Anordnung 1 zu kompensieren. Es wird daher in den oben beschriebenen Arbeitszyklen die Größe des Offsetkorrekturstroms Cc in Abhängigkeit der auftretenden Akquisitionsimpulse und deren Vorzeichen so lange variiert, bis die Akquisitionsimpulse ausbleiben. Dies bedeutet dann nämlich, daß die Arbeitsfrequenz des steuerbaren Oszillators konstant ist, im Frequenzfenster liegt und nicht mehr korrigiert werden muß. Es ist dann eine optimale Korrektur des Offsetstroms des Phasendetektors 4 erreicht worden.

Nach Ende der Einschaltphase und nachdem dieser Offsetstrom in optimaler Weise kompensiert worden ist, löst die Ablaufsteuerung 10 ein Schließen des Schalten 3 aus, so daß nun das Eingangssignal Fin an den Phasenregelkreis 2 angelegt wird. Dieser kann, da die Arbeitsfrequenz seines steuerbaren Oszillators 6 in dem Frequenzfenster liegt, auch dann auf die Frequenz des Eingangssignals Fin rasten, wenn der Phasenregelkreis 2 schmalbandig ausgelegt ist.

Somit ist nicht nur ein sicheres Einrasten des Phasenregelkreises 2 gewährleistet, sondern mittels der erfindungsgemäßen Anordnung 1 auch eine optimale Arbeitsweise des Phasenregelkreises, da ein gegebenenfalls von dem Phasendetektor 4 gelieferter Offsetkorrekturstrom korrigiert ist und somit die beiden Eingangssignale des Phasendetektors 4 die gewünschte Phasenlage zueinander aufweisen. Insbesondere ist zu bedenken, daß die gesamte Anordnung vorteilhaft in einem Schaltkreis integriert in dem jedoch relativ große Streuungen der Schaltungselemente möglich sind. Der Offsetstrom des Phasendetektors 4 kann also beträchtliche Werte erreichen, die störend wirken. Er kann auch so groß sein, daß die Schaltung insgesamt nicht mehr brauchbar ist. In all diesen Fällen kann mittels der erfindungsgemäßen Anordnung 1 eine optimale Arbeitsweise dennoch erzielt werden.

In Fig. 2 ist ein Blockschaltbild der erfindungsgemäßen Anordnung 1 zur Offsetstromkompensation gemäß Fig. 1 dargestellt.

In der Schaltung ist eingangsseitig ein Schalter 21 vorgesehen, welcher, gesteuert durch das Signal Ti, das die Arbeitsphase der erfindungsgemäßen Anordnung angibt, das dem Schalter zugeführte Steuersignal Pn, das die Akquisitionsimpulse steuert, schaltet. Somit wird das Steuersignal Pn während der Arbeitsphase der erfindungsgemäßen Anordnung an einen Dekoder 22 weitergeleitet. Dem Dekoder 22 ist ferner das Zyklussignal Cy zugeführt, das die Korrekturzyklen vorgibt. Der Dekoder 22 ermittelt, ob in einem Arbeitszyklus ein Akquisitionsimpuls in dem Steuersignal Pu auftritt. Tritt ein solcher auf, so gibt der Dekoder 22 ein entsprechendes Steuersignal an ein Register 23. Dieses Steuersignal führt zur Zuschaltung eines weiteren Korrekturteilstroms zu dem Offsetkorrekturstrom. Das Vorzeichen des zugeschalteten Korrekturteilstroms wird durch das Signal Po gesteuert, das dem Register 23 zugeführt wird.

Der Offsetkorrekturstrom Cc, den die Anordnung ausgangsseitig liefert, wird also schrittweise in jedem Korrekturzyklus um einen Korrekturteilstrom erhöht oder vermindert. Das Register 23 liefert ausgangsseitig entsprechende Steuersignale +IO1 bis IOn und -IO1 bis -IOn an ihm nachgeschaltete Stromquellen 24.

In der Fig. 2 sind die Stromquellen 24 in einem Block dargestellt, in dem beispielsweise ein Stromspiegel mit mehreren Ausgangstransistoren entsprechend der Anzahl der gewünschten Korrekturteilströme vorgesehen sein kann.

Mit jedem Korrekturzyklus wird dann ein neuer Korrekturteilstrom zugeschaltet, wenn ein Akquisitionsimpuls auftritt. Das Vorzeichen des zugeschalteten Korrekturteilstroms ist dabei abhängig von dem Akquisitionsimpuls und so gewählt, daß der zugeschaltete Korrekturteilstrom dem Wegdriften der Arbeitsfrequenz des steuerbaren Oszillators 6 der Schaltung gemäß Fig. 1 entgegenwirkt.

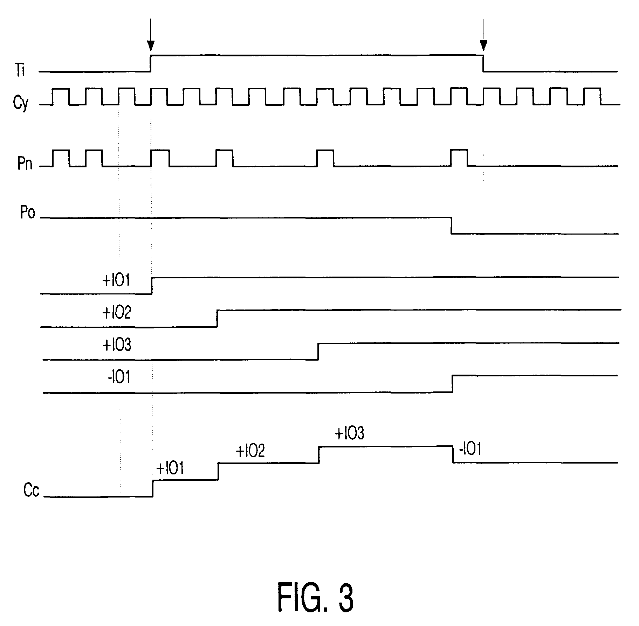

Die Arbeitsweise der erfindungsgemäßen Anordnung 1 zur Offsetstromkompensation gemäß den Fig. 1 und 2 wird nachfolgend anhand eines Zeitdiagramms, das in Fig. 3 dargestellt ist, näher erläutert.

Das Zeitdiagramm gemäß Fig. 3 zeigt das Signal Ti, das den Zeitabschnitt der Einschaltphase angibt, in dem die erfindungsgemäße Anordnung arbeitet. Dieser Zeitabschnitt ist vorteilhaft so gewählt, daß er am Ende der Einschaltphase des Phasenregelkreises liegt. Hiervon wird auch für das Zeitdiagramm gemäß Fig. 3 ausgegangen.

Fig. 3 zeigt, daß das Signal Ti während dieses Zeitabschnitts hohen Pegel hat, während der übrigen Zeit jedoch niedrigen Pegel. Mit dem Ende des hohen Pegels des Signals Ti ist auch das Ende der Einschaltphase des gesamten Phasenregelkreises erreicht.

In der Fig. 3 ist ferner das Zyklussignal Cy dargestellt, das die Arbeitszyklen sowohl des Akquisitionsschaltkreises 7 wie auch die Korrekturzyklen der erfindungsgemäßen Anordnung 1 gemäß Fig. 1 vorgibt.

Ferner ist das Steuersignal Pn dargestellt, das die Akquisitionsimpulse auslöst. Treten in dem Steuersignal Pn Impulse auf; so liefen der Akquisitionsschaltkreis 7 der Anordnung gemäß Fig. 1 Akquisitionsimpulse.

Das Vorzeichen der Akquisitionsimpulse wird durch das Steuersignal Po gesteuert, welches ebenfalls in Fig. 3 dargestellt ist. Bei hohem Pegel des Signals Po haben die Akquisitionsimpulse positives Vorzeichen, bei niedrigem Pegel dieses Signals haben sie negatives Vorzeichen.

In der Fig. 3 sind ferner drei Korrekturteilströme +IO1, +IO2, +IO3 und -IO1 dargestellt, deren Zustandekommen im folgenden näher erläutert werden wird. Diese vier Korrekturteilströme überlagern sich insgesamt zu einem Offsetkorrekturstrom Cc, der ebenfalls in der Fig. 3 dargestellt ist und der der Korrektur des Offsetstroms des Phasendetektors 4 des Phasenregelkreises 2 der Schaltung gemäß Fig. 1 dient.

Die Anordnung 1 zur Offsetstromkompensation ermittelt während ihrer Arbeitsphase also den Zeitabschnitt der Einschaltphase. der durch das Signal Ti und dessen hohen Pegel vorgegeben wird, ob das Signal Pn Akquisitionsimpulse indiziert. In jedem Korrekturzyklus, der durch das Signal Cy vorgegeben wird, wird festgestellt, ob ein solcher Akquisitionsimpuls vorliegt und welches Vorzeichen dieser hat. In dem Beispiel gemäß Fig. 3 tritt zu Beginn der Arbeitsphase in dem Signal Pn tatsächlich ein solcher Impuls auf. Das Signal Po indiziert, daß der Akquisitionsimpuls positives Vorzeichen hat. Somit wird ein Korrekturteilstrom +IO1 dem Offsetkorrekturstrom Cc zugeschaltet. Dies ist in der Figur dadurch erkennbar, daß das Signal +IO1 von niedrigen auf hohen Pegel wechselt und der Wert des Offsetkorrekturstroms Cc sich entsprechend erhöht. In dem nächsten Korrekturzyklus, der durch das Signal Cy vorgegeben wird, tritt kein Akquisitionsimpuls in dem Signal Pn auf. In dem dritten Korrekturzyklus der Anordnung 1 tritt jedoch ein Akquisitionsimpuls auf, der wiederum positives Vorzeichen hat. Es wird daher der nächste Korrekturteilstrom +IO2 dem Offsetkorrekturstrom Cc zugeschaltet. In zwei darauffolgenden Korrekturzyklen treten wiederum keine Akquisitionsimpulse auf, in dem darauffolgenden Korrekturzyklus tritt jedoch wieder ein solcher auf, der wiederum positives Vorzeichen hat, so daß ein weiterer Korrekturteilstrom +IO3 dem Offsetkorrekturstrom Cc zugeschaltet wird.

Die Fig. 3 zeigt, daß sich der Offsetkorrekturstrom somit weiter erhöht und nunmehr bereits den Wert von drei Korrekturteilströmen erreicht hat.

Nach einigen Korrekturzyklen, in denen kein Akquisitionsimpuls auftritt, tritt jedoch gegen Ende des Zeitabschnitts wieder ein solcher auf. Dieser hat jedoch wie das Signal Po indiziert, negatives Vorzeichen. Somit ist die Arbeitsfrequenz des steuerbaren Oszillators 6 nunmehr in entgegengesetzter Richtung abgedriftet und muß entsprechend korrigiert werden. Dies wird mittels des Akquisitionsschaltkreises durch einen Akquisitionsimpuls negativen Vorzeichens vorgenommen.

Für die erfindungsgemäße Anordnung bedeutet dies jedoch, daß nunmehr ein Offsetkorrekturteilstrom mit negativem Vorzeichen zuzuschalten ist, welcher in der Figur mit -IO1 gekennzeichnet ist.

Die Fig. 3 zeigt, daß der gesamte Offsetkorrekturstrom Cc sich entsprechend verringert.

Nach diesem Korrekturzyklus ist das Ende sowohl der Einschaltphase wie auch des Zeitabschnitts, in dem die erfindungsgemäße Anordnung arbeitet, erreicht und es ist ein Offsetkorrekturstrom Cc ermittelt worden, welcher einen von dem Phasendetektor 4 gemäß der Anordnung 1 gelieferten Offsetstrom kompensiert und somit eine optimale Arbeitsweise des Phasenregelkreises 2 der Schaltung gemäß Fig. 1 gewährleistet.

## Patentansprüche

1. Anordnung zur Offsetstromkompensation eines Phasendetektors (4), welcher in einem Phasenregelkreis (2) vorgesehen ist, dem ein Akqusitionsschaltkreis (7) zugeordnet ist, welcher in einer Einschaltphase des Phasenregelkreises (2) vor Anlegung eines Eingangssignals an den Phasenregelkreis (2) Akquisitionsimpulse in ein in dem Phasenregelkreis (2) vorgesehenes Schleifenfilter (5) einspeist, um die Arbeitsfrequenz eines in dem Phasenregelkreis vorgesehenen steuerbaren Oszillators (6) in ein vorgegebenes Frequenzfensters zu bringen, dadurch gekennzeichnet,
daß die Anordnung (1) während wenigstens eines Zeitabschnitts der Einschaltphase bei einem Auftreten von Akquisitionsimpulsen einen Offsetkorrekturstrom ermittelt, welcher der Kompensation des Offsetstroms des Phasendetektors (4) dient, wobei die Größe und das Vorzeichen des Offsetkorrekturstroms abhängig von der Häufigkeit und dem Vorzeichen der Akquisitionsimpulse so gewählt wird, daß am Ende der Einschaltphase keine Akquisitionsimpulse mehr auftreten,
und daß die Anordnung (1) den so ermittelten Offsetkorrekturstrom dem Ausgangssignal des Phasenkomparators (4) auch während des Betriebs des Phasenregelkreises außerhalb der Einschaltphase überlagert.

2. Anordnung nach Anspruch 1, dadurch gekennzeichnet, daß die Anordnung (1) die Ermittlung der Größe und des Vorzeichens des Offsetkorrekturstroms in Korrekturzyklen vornimmt, wobei in jedem Zyklus in Abhängigkeit vom Auftreten eines Akquisitionsimpulses und dessen Vorzeichen dem Offsetkorrekturstrom ein Korrekturteilstrom mit einem zur Verringerung des Offsetstroms geeignetem Vorzeichen zugeschaltet wird.

3. Anordnung nach Anspruch 2, dadurch gekennzeichnet, daß in der Anordnung (1) ein Dekoder (22) vorgesehen ist, welcher Steuersignale, mittels derer die Akquisitionsimpulse und deren Vorzeichen gesteuert werden, auswertet und der ein Register (23) ansteuert, mittels weichem die Korrekturteilströme schaltbar sind, welche von Stromquellen (24) geliefert werden und gleichen Betrag aber beide Vorzeichen aufweisen.

4. Anordnung nach Anspruch 3, dadurch gekennzeichnet, daß mittels des Registers (23) und der Stromquellen (24) jeweils n Korrekturteilströme mit positivem und negativem Vorzeichen schaltbar sind, welche jeweils gleiche Größe aufweisen.

5. Anordnung nach Anspruch 2, dadurch gekennzeichnet, daß die Korrekturzyklen entsprechend Arbeitszyklen des Akquisitionsschaltkreises (7) gewählt werden.

6. Anordnung nach Anspruch 1, dadurch gekennzeichnet, daß die Anordnung (1) eine neue Ermittlung des Offsetkorrekturstroms nach jeder Aktivierung der Stromversorgung des Phasenregelkreises (2) während wenigstens eines Zeitabschnitts der Einschaltphase vornimmt.

7. Anordnung nach Anspruch 1, dadurch gekennzeichnet, daß dem Phasenregelkreis (2) ein Schalter (3) vorgeschaltet ist, der ein Eingangssignal erst nach Abschluß der Einschaltphase auf den Phasenregelkreis (2) schaltet.

8. Anordnung nach Anspruch 1, dadurch gekennzeichnet, daß die Anordnung (1) die Auswertung der Akqusitionsimpulse und die Ermittlung des Offsetkorrekturstroms während einer vorgebbaren Zeitspanne vornimmt, welche am Ende der Einschaltphase liegt und deren Beginn so gewählt ist, daß der Akquisitionschaltkreis (7) die Arbeitsfrequenz des steuerbaren Oszillators (6) mittels der Akqusitionsimpulse wenigstens in die Nähe des Frequenzfensters gebracht hat.

9. Anordnung nach Anspruch 1, dadurch gekennzeichnet, daß der Offsetkorrekturstrom in dem Phasenkomparator Strömen überlagert wird, welche dort mittels Stromquellen erzeugt werden, die einem in dem Phasenkomparator vorgesehenen Differenzverstärker zugeordnet sind.

10. Anordnung nach Anspruch 1, dadurch gekennzeichnet, daß der Offsetkorrekturstrom dem Ausgangssignal des Phasenkomparators überlagert wird.

11. Phasenregelkreis mit einer Anordnung (1) zur Offsetstromkompensation nach einem der Ansprüche 1 bis 10.
